# EUROPEAN PATENT APPLICATION

(11) **EP 4 481 801 A1**
(43) Date of publication of application: **25.12.2024**
(21) Application number: 23213926.1
(22) Date of filing: 04.12.2023
(51) Int. Cl.: H01L 21/8238, H01L 27/092, H01L 29/06, H01L 29/66, H01L 29/775, H01L 29/786

(54) **FORKSHEET DEVICES WITH DIELECTRIC SPINE AT CELL BOUNDARY**

(30) Priority: 21.06.2023 US 202318212295
(71) Applicant: Intel Corporation, Santa Clara, CA 95054 (US)
(72) Inventor: Yemenicioglu, Sukru, Portland, 97229 (US); Guler, Leonard P., Hillsboro, 97124 (US); Liu, Shengsi, Portland, 97229 (US)
(74) Representative: Goddar, Heinz J.

(57) **Abstract**

Techniques are provided herein to form semiconductor devices having cells that include forksheet devices with source or drain regions of the same dopant type on both sides of the forksheet dielectric spine. The techniques can be used in any number of integrated circuit applications and are particularly useful with respect to logic and memory cells. The forksheet devices may include all p-type source or drain regions on both sides of the dielectric spine or all n-type source or drain regions on both sides of the dielectric spine. Using forksheet devices with the same dopant type allows for both forksheet transistors and gate-all-around (GAA) transistors to be included within the same cell. The cell boundaries may also be placed along the forksheet dielectric spines rather than along gate cuts, which provides greater flexibility when designing multi-height cells.

## Description

### FIELD OF THE DISCLOSURE

The present disclosure relates to integrated circuits, and more particularly, to forksheet devices.

### BACKGROUND

As integrated circuits continue to scale downward in size, a number of challenges arise. For instance, reducing the size of memory and logic cells is becoming increasingly more difficult, particularly given competing interests in a relatively small amount of space. For instance, repeating units of devices, often called cells or standard cells, can impose limitations on the arrangement of certain transistor structures that fail to maximize the available footprint on a given die. Accordingly, there remain a number of non-trivial challenges with respect to designing layout of various cells of the integrated circuit structure for improved PPA (power, performance, and area) performance.

### BRIEF DESCRIPTION OF THE DRAWINGS

Figure 1A is a plan view of a standard cell having dielectric spine portions of forksheet transistors at the cell boundaries, in accordance with an embodiment of the present disclosure.
Figure 1B is a plan view of a plurality of adjacent standard cells having dielectric spines of forksheet transistors at the cell boundaries, with the same dopant type on both sides of a given spine, in accordance with an embodiment of the present disclosure.
Figure 1C is a cross-section view through a gate trench of the plurality of adjacent standard cells of Figure 1B showing dielectric spines of forksheet devices at the cell boundaries, with intra-cell gate cuts, in accordance with an embodiment of the present disclosure.
Figure 2A is a plan view of another cell architecture that includes forksheet devices and gate-all-around (GAA) devices, in accordance with an embodiment of the present disclosure.
Figure 2B is a cross-section view through a gate trench of the cell architecture of Figure 2A showing both forksheet devices and GAA devices with gate cuts between them, in accordance with an embodiment of the present disclosure.
Figure 3A is a plan view of another multicell architecture that includes forksheet devices and gate-all-around (GAA) devices, in accordance with an embodiment of the present disclosure.
Figures 3B and 3C are isometric views of the cell architecture of Figure 3A showing forksheet devices and GAA devices overlapping with one another along the width of a cell, in accordance with an embodiment of the present disclosure.
Figures 4A - 4G are cross-sectional views that illustrate stages in an example process for forming an integrated circuit configured with both forksheet and GAA devices, in accordance with some embodiments of the present disclosure.
Figure 5 illustrates a cross-section view of a chip package containing one or more semiconductor dies, in accordance with some embodiments of the present disclosure.
Figure 6 illustrates a computing system including one or more integrated circuits, as variously described herein, in accordance with an embodiment of the present disclosure.

Although the following Detailed Description will proceed with reference being made to illustrative embodiments, many alternatives, modifications, and variations thereof will be apparent in light of this disclosure. As will be further appreciated, the figures are not necessarily drawn to scale or intended to limit the present disclosure to the specific configurations shown. For instance, while some figures generally indicate perfectly straight lines, right angles, and smooth surfaces, an actual implementation of an integrated circuit structure may have less than perfect straight lines, right angles (e.g., some features may have tapered sidewalls and/or rounded corners), and some features may have surface topology or otherwise be non-smooth, given real world limitations of the processing equipment and techniques used.

### DETAILED DESCRIPTION

Techniques are provided herein to form semiconductor devices having cells that include forksheet devices with source or drain regions of the same dopant type on both sides of the forksheet dielectric spine. The techniques can be used in any number of integrated circuit applications and are particularly useful with respect to logic and memory cells. The forksheet devices may include all p-type source or drain regions on both sides of the dielectric spine or all n-type source or drain regions on both sides of the dielectric spine. Using forksheet devices with the same dopant type allows for both forksheet transistors and gate-all-around (GAA) transistors to be included within the same cell. The cell boundaries may also be placed along the forksheet dielectric spines rather than along gate cuts, which provides greater flexibility when designing multi-height cells. Numerous variations and embodiments will be apparent in light of this disclosure.

### General Overview

As previously noted above, there remain a number of non-trivial challenges with respect to formation of various semiconductor structures. Forksheet devices (also known as forkFET devices) include a dielectric spine extending down the middle of the nanoribbons, thus splitting the nanoribbons into nanosheets on either side of the dielectric spine. Standard cell architectures that only include forksheet devices can limit the maximum drive per gate in a given cell. Existing architectures also constrain the minimum cell height.

Thus, and in accordance with an embodiment of the present disclosure, techniques are provided herein to form standard cell architectures with forksheet devices that have the same dopant type (e.g., n-type or p-type) on both sides of the dielectric spine. This allows for the forksheet spines to be placed along the cell boundaries and opens the possibility of including GAA devices within multi-height cells. The inclusion of both forksheet devices and GAA devices in the same cell arrangement can provide the benefits of both types of devices (e.g., a significant drive boost using the GAA devices and less parasitic capacitance using the forksheet devices).

According to some embodiments, each forksheet device is designed to have only n-type source or drain regions or only p-type source or drain regions on both sides of the dielectric spine. The n-type source or drain regions may include silicon doped with n-type dopants such as phosphorous. The p-type source or drain regions may include silicon germanium doped with p-type dopants such as boron. Some cell designs can incorporate both forksheet devices and GAA devices by forming one or more forksheet devices without the dielectric spine, thus creating wide-channel GAA devices, according to some embodiments. In some examples, the dielectric spine continues along the width of a first number of cells, but does not continue along the width of a second number of cells in the same row of cells. Accordingly, the first number of cells include forksheet devices along the dielectric spine and the second number of cells include GAA devices aligned with the forksheet devices along the width direction of the cells.

According to an embodiment, an integrated circuit includes a first semiconductor device having a first semiconductor region extending in a first direction from a first source or drain region, and a first gate structure extending in a second direction over the first semiconductor region. The integrated circuit also includes a second semiconductor device having a second semiconductor region extending in the first direction from a second source or drain region, and a second gate structure extending in the second direction over the second semiconductor region. The second source or drain region is adjacent to the first source or drain region along the second direction. The integrated circuit also includes a dielectric wall extending in the first direction between and contacting both the first semiconductor region and the second semiconductor region and extending in the first direction between both the first source or drain region and the second source or drain region. The first source or drain region and the second source or drain region both have n-type dopants, or both have p-type dopants.

According to another embodiment, an integrated circuit includes a first semiconductor device having a first semiconductor region extending in a first direction from a first source or drain region to a second source or drain region, and a first gate structure extending in a second direction over the first semiconductor region, a first dielectric wall extending in the first direction and contacting the first semiconductor region, and extending in the first direction adjacent to both the first source or drain region and the second source or drain region, a second dielectric wall extending in the first direction and adjacent to the first semiconductor device, such that the first gate structure extends in the second direction from the first dielectric wall to the second dielectric wall, and a second semiconductor device having a second semiconductor region extending in the first direction from a third source or drain region to a fourth source or drain region, and a second gate structure extending in the second direction from the second dielectric wall and surrounding the second semiconductor region.

According to another embodiment, an integrated circuit includes a first semiconductor device having a first semiconductor region extending in a first direction from a first source or drain region, and a first gate structure extending in a second direction over the first semiconductor region. The integrated circuit also includes a second semiconductor device having a second semiconductor region extending in the first direction from a second source or drain region, and a second gate structure extending in the second direction over the second semiconductor region. The second source or drain region is adjacent to the first source or drain region along the second direction. The integrated circuit also includes a third semiconductor device having a third semiconductor region extending in the first direction from a third source or drain region and collinearly with the first semiconductor region and the second semiconductor region, and a third gate structure extending in the second direction over the third semiconductor region. The third gate structure is spaced from the first gate structure and second gate structure in the first direction. The integrated circuit also includes a dielectric wall extending in the first direction between and contacting both the first semiconductor region and the second semiconductor region, and extending in the first direction between both the first source or drain region and the second source or drain region. The dielectric wall does not intersect the third semiconductor region.

The techniques can be used with any type of non-planar transistors, including finFETs (sometimes called double-gate transistors, or tri-gate transistors), or nanowire and nanoribbon transistors (sometimes called gate-all-around transistors), or forkFETs to name a few examples. The source and drain regions can be, for example, doped portions of a given fin or substrate, or epitaxial regions that are deposited during an etch-and-replace source/drain forming process. The dopant-type in the source and drain regions will depend on the polarity of the corresponding transistor. The gate structure can be implemented with a gate-first process or a gate-last process (sometimes called a replacement metal gate, or RMG, process), or any other gate formation process. Any number of semiconductor materials can be used in forming the transistors, such as group IV materials (e.g., silicon, germanium, silicon germanium) or group III-V materials (e.g., gallium arsenide, indium gallium arsenide).

Use of the techniques and structures provided herein may be detectable using tools such as electron microscopy including scanning/transmission electron microscopy (SEM/TEM), scanning transmission electron microscopy (STEM), nano-beam electron diffraction (NBD or NBED), and reflection electron microscopy (REM); composition mapping; x-ray crystallography or diffraction (XRD); energy-dispersive x-ray spectroscopy (EDX); secondary ion mass spectrometry (SIMS); time-of-flight SIMS (ToF-SIMS); atom probe imaging or tomography; local electrode atom probe (LEAP) techniques; 3D tomography; or high resolution physical or chemical analysis, to name a few suitable example analytical tools. For instance, in some example embodiments, such tools may indicate the use of forksheet devices where each of the source or drain regions of the forksheet device has the same dopant profile (n-type or p-type) on both sides of the forksheet dielectric spine. In some examples, such tools may indicate the presence of both forksheet devices and GAA devices within the same repeating cell architecture. Numerous configurations and variations will be apparent in light of this disclosure.

It should be readily understood that the meaning of "above" and "over" in the present disclosure should be interpreted in the broadest manner such that "above" and "over" not only mean "directly on" something but also include the meaning of over something with an intermediate feature or a layer therebetween. Further, spatially relative terms, such as "beneath," "below," "lower," "above," "upper," "top," "bottom," and the like, may be used herein for ease of description to describe one element or feature's relationship to another element (s) or feature (s) as illustrated in the figures. The spatially relative terms are intended to encompass different orientations of the device in use or operation in addition to the orientation depicted in the figures. The apparatus may be otherwise oriented (rotated 90 degrees or at other orientations) and the spatially relative descriptors used herein may likewise be interpreted accordingly.

As used herein, the term "layer" refers to a material portion including a region with a thickness. A monolayer is a layer that consists of a single layer of atoms of a given material. A layer can extend over the entirety of an underlying or overlying structure, or may have an extent less than the extent of an underlying or overlying structure. Further, a layer can be a region of a homogeneous or inhomogeneous continuous structure, with the layer having a thickness less than the thickness of the continuous structure. For example, a layer can be located between any pair of horizontal planes between, or at, a top surface and a bottom surface of the continuous structure. A layer can extend horizontally, vertically, and/or along a tapered surface. A layer can be conformal to a given surface (whether flat or curvilinear) with a relatively uniform thickness across the entire layer.

Materials that are "compositionally different" or "compositionally distinct" as used herein refers to two materials that have different chemical compositions. This compositional difference may be, for instance, by virtue of an element that is in one material but not the other (e.g., SiGe is compositionally different than silicon), or by way of one material having all the same elements as a second material but at least one of those elements is intentionally provided at a different concentration in one material relative to the other material (e.g., SiGe having 70 atomic percent germanium is compositionally different than from SiGe having 25 atomic percent germanium). In addition to such chemical composition diversity, the materials may also have distinct dopants (e.g., gallium and magnesium) or the same dopants but at differing concentrations. In still other embodiments, compositionally distinct materials may further refer to two materials that have different crystallographic orientations. For instance, (110) silicon is compositionally distinct or different from (100) silicon. Creating a stack of different orientations could be accomplished, for instance, with blanket wafer layer transfer. If two materials are elementally different, then one of the material has an element that is not in the other material.

### Architecture

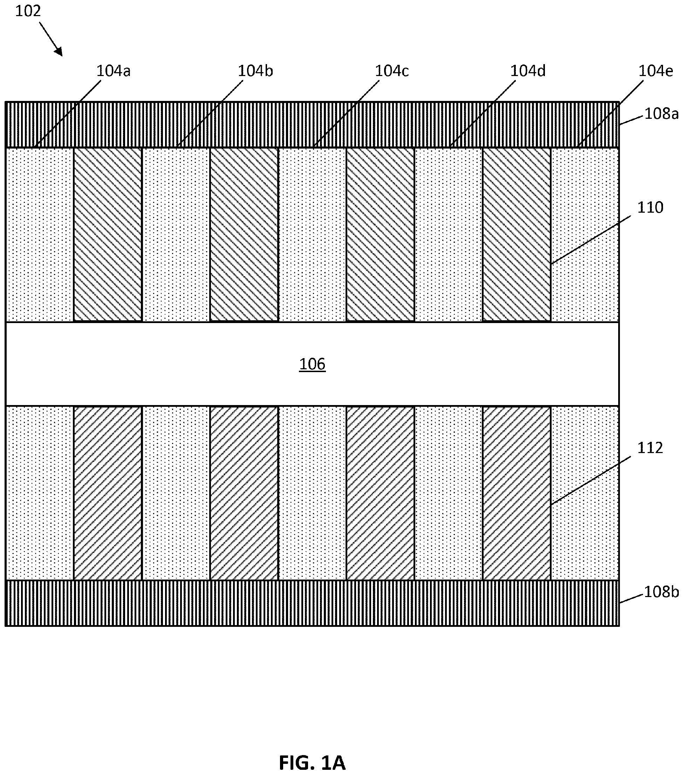

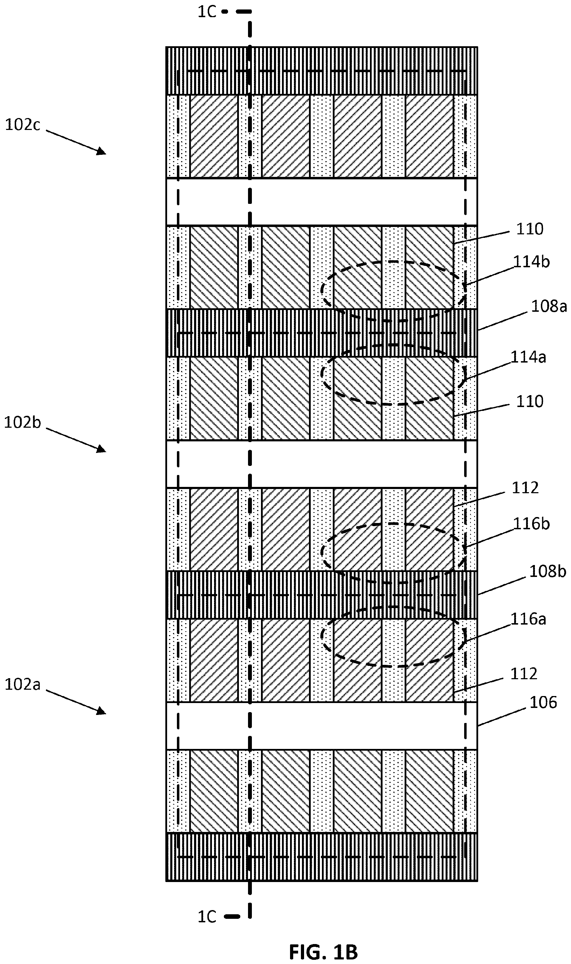

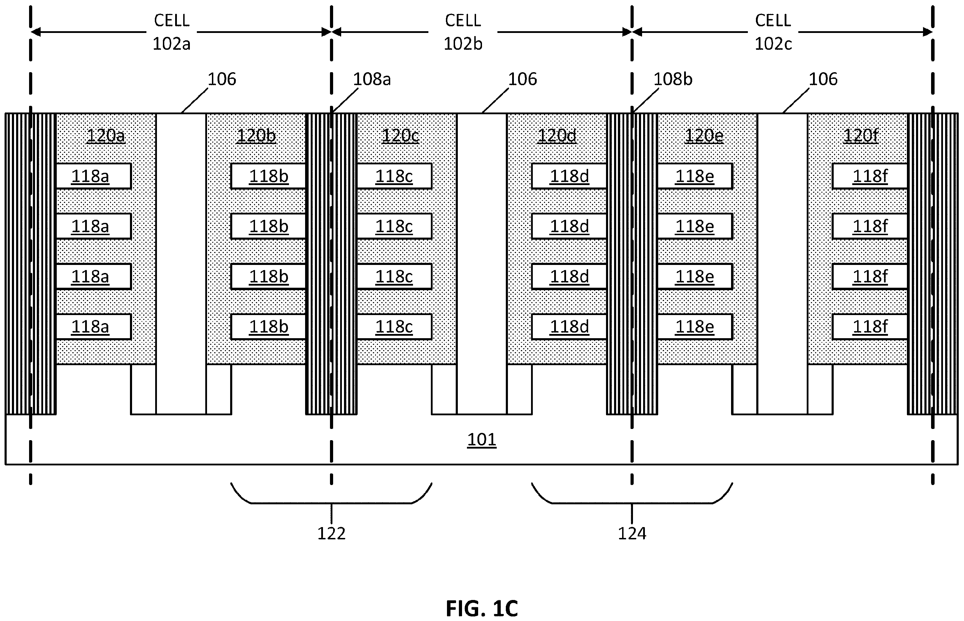

Figure 1A is a plan view of a standard cell 102 within an integrated circuit structure, according to some embodiments. Cell 102 may be arranged adjacent to any number of other similar cells in an array of rows and columns with cell boundaries identified by the edges of cell 102 as illustrated in Figure 1. It should be understood that the cell boundary does not refer to a specific structure and instead identifies a delineation between repeating transistor arrangements. Each repeating cell 102 contains the same arrangement of transistor structures, according to some embodiments.

According to some embodiments, a given cell 102 includes at least two transistor devices. In some examples, cell 102 includes parallel gate structures 104a - 104e that run lengthwise along a first direction (e.g., along a height direction of the cell). In some examples, gate structures 104a and 104e may be dummy structures or replaced with a dielectric material as these structures may act as barriers to separate adjacent cells along a given row of cells. Gate structures 104a - 104e may be interrupted by a gate cut 106 that extends lengthwise along a second direction different from the first direction (e.g., orthogonal to the first direction or along a width direction of the cell). Gate cut 106 may be any suitable dielectric material to electrically isolate structures on either side of gate cut 106 from each other. Accordingly, cell 102 includes six separate gate structures (on both sides of gate cut 106) and thus includes six transistors.

According to some embodiments, the top three transistors are part of a first plurality of forksheet structures that each includes a first dielectric spine 108a extending lengthwise along the second direction, and the bottom transistors are part of a second plurality of forksheet structures that each include a second dielectric spine 108b extending lengthwise along the second direction. Dielectric spine 108a/108b may be any suitable dielectric material and may be the same dielectric material as gate cut 106. Dielectric spine 108a/108b may include silicon dioxide, silicon nitride, silicon oxynitride, aluminum oxide, or spin-on glass to name a few examples. The top three transistors include gate structures that extend over corresponding semiconductor bodies that themselves extend in the second direction between corresponding first source or drain regions 110, according to some embodiments. The bottom three transistors include gate structures that extend over corresponding semiconductor bodies that themselves extend in the second direction between corresponding second source or drain regions 112, according to some embodiments. First source or drain regions 110 are all n-type regions or are all p-type regions and second source or drain regions are all n-type regions or are all p-type regions. According to some embodiments, first source or drain regions 110 have the opposite dopant type compared to second source or drain regions 112.

Due to the repeating nature of cell 102 across an array of cells, the first plurality of forksheet structures includes another set of transistors on the opposite side of first dielectric spine 108a having source or drain regions with the same dopant type as first source or drain regions 110, according to some embodiments. Similarly, the second plurality of forksheet structures includes another set of transistors on the opposite side of second dielectric spine 108b having source or drain regions with the same dopant type as second source or drain regions 112. This can be seen more clearly in Figures 1B and 1C, which illustrate a plan view of a portion of an array of cells and a cross-section view along the gate trench of the array of cells, respectively. The cell boundaries are identified with dashed lines between each of cells 102a - 102c.

In Figure 1B, a first transistor 114a on one side of first dielectric spine 108a and a second transistor 114b on an opposite side of first dielectric spine 108a are part of a single forksheet structure that straddles the cell boundary between cells 102b and 102c, according to some embodiments. The source or drain regions 110 of both first transistor 114a and second transistor 114b share the same dopant type (either n-type or p-type). According to some embodiments, forksheet structures having source or drain regions of one type alternate with forksheet structures having source or drain regions of the other type along the first direction. For instance, in the illustrated example, a third transistor 116a on one side of second dielectric spine 108b and a second transistor 116b on an opposite side of second dielectric spine 108b are part of a single forksheet structure that straddles the cell boundary between cells 102b and 102a, according to some embodiments. The source or drain regions 112 of both second transistor 116a and second transistor 116b share the same dopant type (either n-type or p-type) and may be the opposite dopant dope from source or drain regions 110.

Figure 1C illustrates a cross-section view along a gate trench through multiple cells in a given column of cells (e.g., along the first direction or cell height direction), as indicated with the bolded 1C-1C line in Figure 1B, according to some embodiments. The various forksheet structures may be formed over a substrate 101. Substrate 101 can be, for example, a bulk substrate including group IV semiconductor material (such as silicon, germanium, or silicon germanium), group III-V semiconductor material (such as gallium arsenide, indium gallium arsenide, or indium phosphide), and/or any other suitable material upon which transistors can be formed. Alternatively, the substrate can be a semiconductor-on-insulator substrate having a desired semiconductor layer over a buried insulator layer (e.g., silicon over silicon dioxide). Alternatively, the substrate can be a multilayer substrate or superlattice suitable for forming nanowires or nanoribbons (e.g., alternating layers of silicon and SiGe, or alternating layers indium gallium arsenide and indium phosphide). Any number of substrates can be used. In some embodiments, substrate 101 is removed and replaced with one or more backside interconnect layers to form backside signal and power routing.

Each transistor includes a semiconductor body extending in the second direction, such as nanosheets 118a - 118f. Each vertical set of nanosheets represents the semiconductor body of a single transistor. Each transistor may include any number of nanosheets. Although each of the illustrated devices includes 4 nanosheets, each device may instead include only three nanosheets, in some examples. According to some embodiments, gate cuts 106 extend through an entire thickness of the gate structures to isolate different gate structures 120a - 120f along the first direction. Each gate cut 106 may have a width along the first direction, for example, between about 5 nm and about 30 nm. Each gate structure 120a - 120f extends over a corresponding semiconductor body to form a single transistor. In the case of a forksheet device such as shown in the cross-section of Figure 1C, note that the gate structure 120 extends along upper and lower sides of each nanosheet 118 as well as along the nanosheet end that is distal to the dielectric spine. Such a laterally-extending forksheet gate structure that is on side and end surfaces of a nanosheet-based channel region is similar to a vertically-extending finFET gate structure that is on side and top surfaces of a fin-based channel region.

According to some embodiments, a first forksheet structure 122 includes nanosheets 118b and gate structure 120b on one side of first dielectric spine 108a and includes nanosheets 118c and gate structure 120c on the opposite side of first dielectric spine 108a. Each set of nanosheets 118b and 118c extends in the second direction between source or drain regions that have the same dopant type (either n-type or p-type). According to some embodiments, a second forksheet structure 124 includes nanosheets 118d and gate structure 120d on one side of second dielectric spine 108b and includes nanosheets 118e and gate structure 120e on the opposite side of second dielectric spine 108b. Each set of nanosheets 118d and 118e extends in the second direction between source or drain regions that have the same dopant type (either n-type or p-type) and that are the opposite dopant type compared to the source or drain regions of first forksheet structure 122, according to some embodiments. The cell boundaries may be aligned along the various dielectric spines of the forksheet structures to differentiate between cells along the first direction.

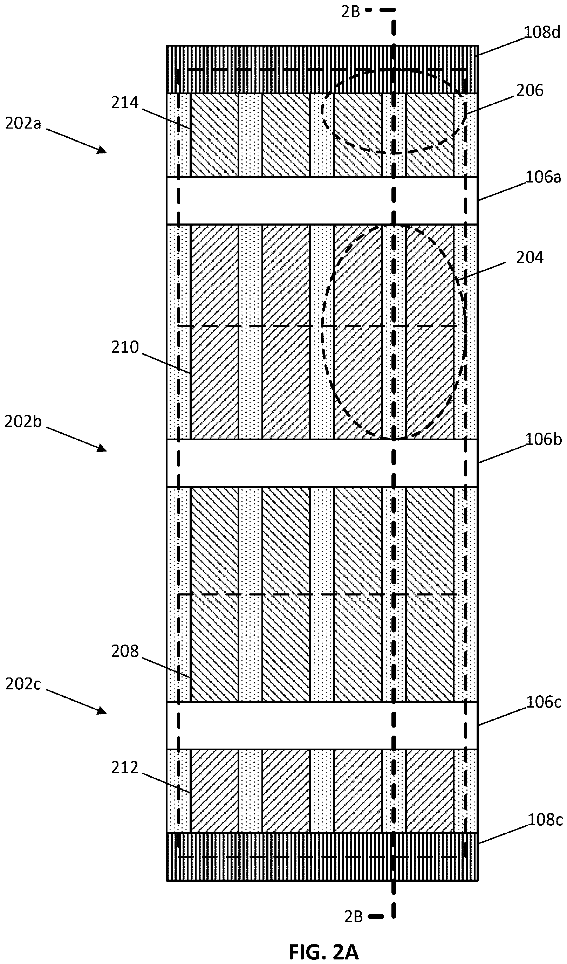

As discussed above, the arrangement of forksheet devices across the cell boundaries allows for the integration of both forksheet devices and GAA devices within the same cell architecture by removing any number of dielectric spines. Figure 2A illustrates one example where the dielectric spines along the cell boundaries between cells 202a and 202b and between cells 202b and 202c have been removed to form both forksheet devices and GAA devices, according to an embodiment. The resulting structure may provide a larger cell with an extended height (e.g., a triple cell height) between dielectric spines 108c and 108d of the remaining forksheet devices. Accordingly, the triple-height cell illustrated in Figure 2A may be repeated any number of times in an array to form the integrated circuit.

According to some embodiments, the omission of a given forksheet dielectric spine leaves a GAA device 204 between adjacent gate cuts 106a - 106c. The cell may still also include one or more forksheet structures to provide forksheet devices such as forksheet device 206. More than one GAA device within the same cell may be different transistor types and more than one forksheet device within the same cell may be different transistor types. For example, one set of GAA devices may include source or drain regions 208 having a same dopant type (n-type or p-type) and another set of GAA devices may include source or drain regions 210 having the opposite dopant type. Similarly, one set of forksheet devices may include source or drain regions 212 having a same dopant type (n-type or p-type) and another set of forksheet devices may include source or drain regions 214 having the opposite dopant type.

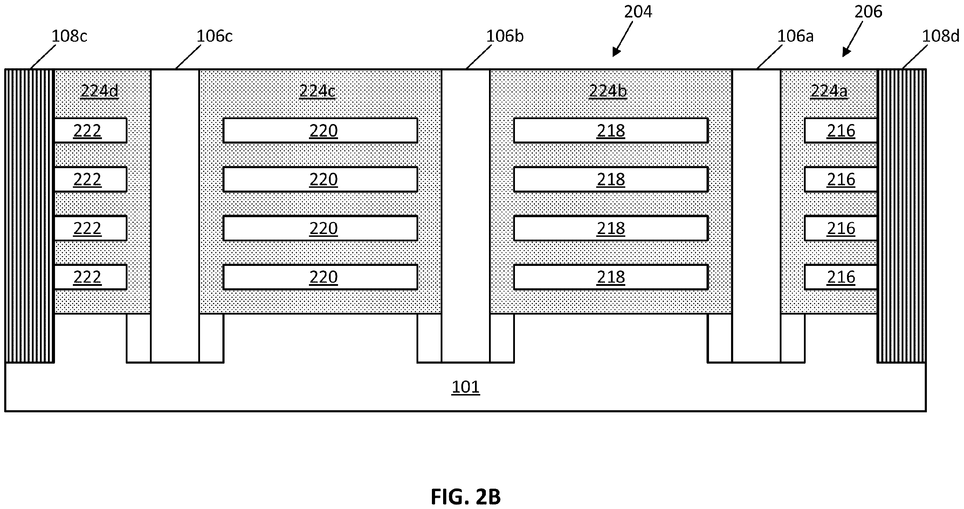

Figure 2B illustrates a cross-section view along a gate trench through multiple cells in a given column of cells (e.g., along the first direction or cell height direction), as indicated with the bolded 2B-2B line in Figure 2A, according to some embodiments. Several nanosheets (part of forksheet devices) and nanoribbons (part of GAA devices) can be seen along the height of the cell. For example, nanosheets 216 extend between corresponding source or drain regions (into and out of the page) as part of forksheet device 206 having dielectric spine 108d and gate structure 224a. Gate structure 224a may extend along the first direction between dielectric spine 108d and an adjacent gate cut 106a. According to some embodiments, a GAA device 204 may be arranged on an opposite side of gate cut 106a. Thus, a set of nanoribbons 218 extend between corresponding source or drain regions (into and out of the page) as part of GAA device 204 having gate structure 224b. Gate structure 224b extends in the first direction between gate cuts 106b and 106c and completely around nanoribbons 218. Similar transistor structures may be repeated within the cell as shown with nanoribbons 220 and nanosheets 222. Each transistor may include any number of nanosheets (for forksheet devices) or nanoribbons (for GAA devices). Although each of the illustrated devices includes 4 nanosheets/nanoribbons, each device may instead include only three nanosheets/nanoribbons, in some examples.

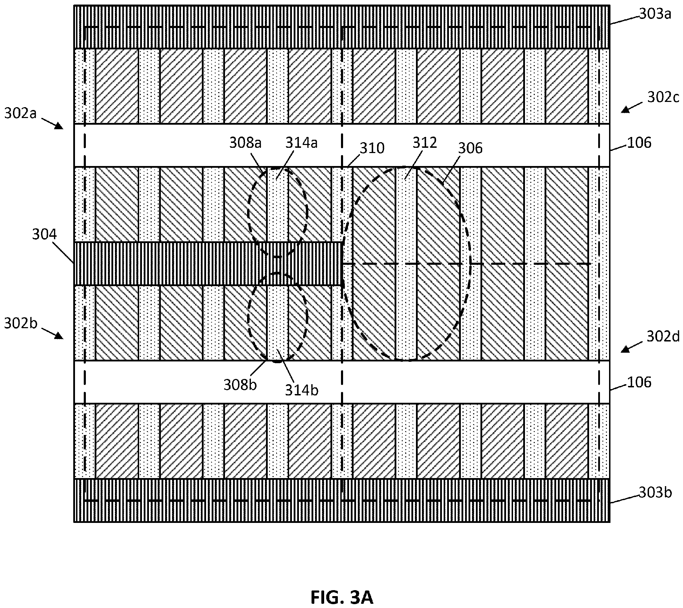

According to some embodiments, a given dielectric spine may extend in the second direction across some cell widths, but not across others, which forms GAA devices aligned across from forksheet devices in the second direction. Figure 3A illustrates a plan view of an example array of four cells 302a - 302d in a 2 x 2 arrangement. In some examples, the illustrated arrangement could be repeated as a single cell with a double height and double width. The top and bottom cell boundaries of the illustrated arrangement may include dielectric spines 303a and 303b that extend across an entire double cell width. According to some embodiments, another dielectric spine 304 may extend along the second direction across the boundary between cells 302a and 302b but does not continue to extend across the boundary between cells 302c and 302d. As a result, GAA devices, such as GAA device 306, are formed across the boundary between cells 302c and 302d and forksheet devices, such as forksheet devices 308a and 308b, are formed across the boundary between cells 302a and 302b.

A dummy gate structure 310 may extend between GAA device 306 and forksheet devices 308a and 308b. In some examples, dielectric spine 304 may extend partially into dummy gate structure 310 in the second direction. Dummy gate structure 310 may be partially or fully replaced with a dielectric material, according to some embodiments.

GAA device 306 includes a gate structure 312 extending in the first direction over semiconductor nanoribbons, which extend in the second direction between corresponding source and drain regions. First forksheet device 308a includes a gate structure 314a that extends over first semiconductor nanosheets, which extend in the second direction between corresponding source and drain regions, and second forksheet device 308b includes a gate structure 314b that extends over second semiconductor nanosheets, which extend in the second direction between corresponding source and drain regions. According to some embodiments, the nanoribbons of GAA device 306 extend along the second direction and colinearly with the nanosheets of first forksheet device 308a and second forksheet device 308b. Additionally, the corresponding source or drain regions of GAA device 306 and of each of first forksheet device 308a and second forksheet device 308b have the same dopant type (e.g., either all n-type or all p-type).

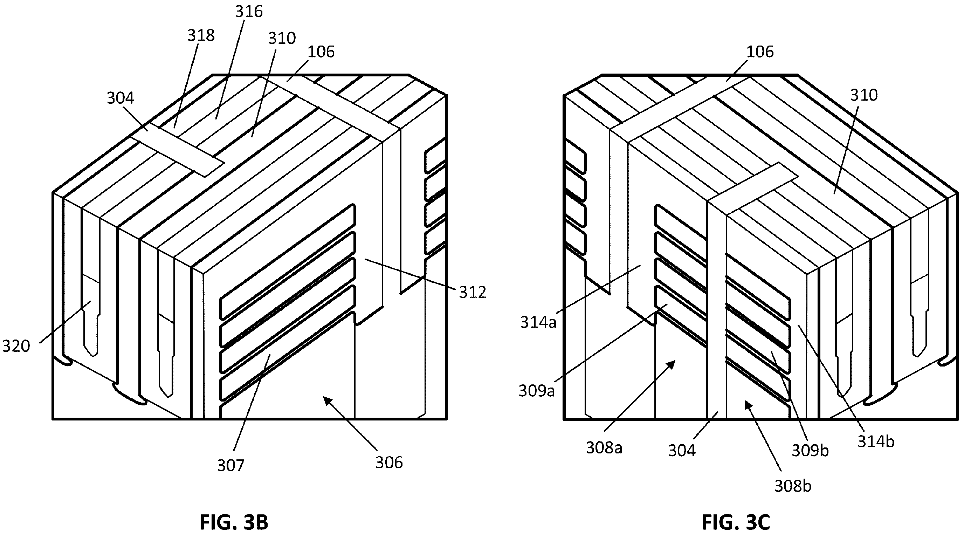

Figures 3B and 3C illustrate isometric views of the integrated circuit illustrated in Figure 3A showing GAA device 306 and forksheet devices 308a and 308b. According to some embodiments, dielectric spine 304 extends in the second direction across various gate structures and also across various sets of diffusion contacts 316 and spacer structures 318. Diffusion contacts 316 include any suitable conductive material that provides an ohmic contact to the underlying source or drain region 320. In some examples, diffusion contacts 316 include any of tungsten, ruthenium, molybdenum, or cobalt. Spacer structures 318 include any suitable dielectric material to separate the source/drain trenches (having source or drain regions and diffusion contacts) from the gate trenches (having the gate structures). In some examples, spacer structures 318 include any of silicon dioxide, silicon nitride, or silicon oxynitride.

According to some embodiments, GAA device 306 includes a set of nanoribbons 307 with gate structure 312 extending along the first direction and completely around nanoribbons 307. First forksheet device 308a includes a first set of nanosheets 309a having gate structure 314a extending in the first direction partially over nanosheets 309a up to dielectric spine 304, and second forksheet device 308b includes a second set of nanosheets 309b having gate structure 314b extending in the first direction partially over nanosheets 309b up to dielectric spine 304, according to some embodiments. Nanoribbons 307 are extensions of the nanosheets 309a and 309b, such that nanoribbons 307 extend in the second direction colinearly with nanosheets 309a and 309b, according to some embodiments. Furthermore, the width of nanoribbons 307 along the first direction is substantially equal to the combined width of nanosheets 309a, nanosheets 309b, and dielectric spine 304 along the first direction. Each transistor may include any number of nanosheets (for forksheet devices) or nanoribbons (for GAA devices). Although each of the illustrated devices includes 4 nanosheets/nanoribbons, each device may instead include only three nanosheets/nanoribbons, in some examples.

### Fabrication Methodology

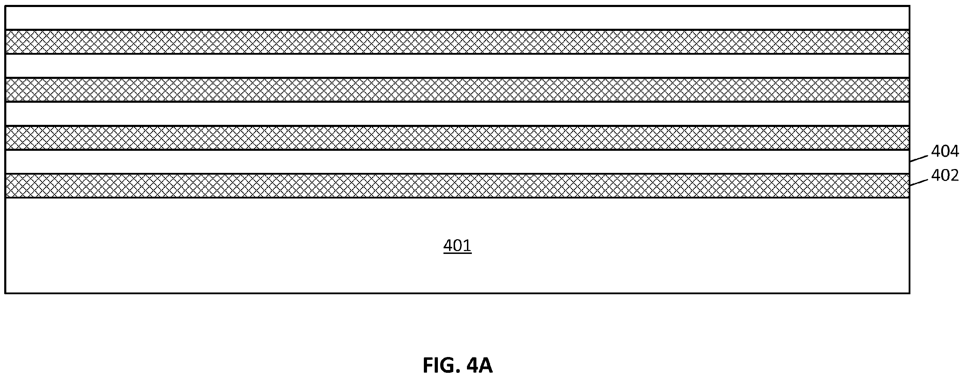

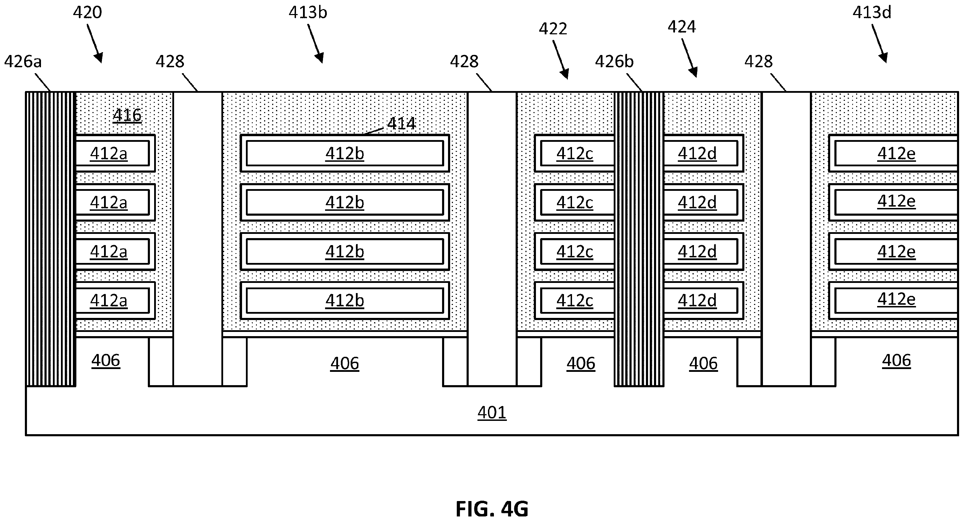

Figures 4A - 4G are cross-sectional views that collectively illustrate an example process for forming an integrated circuit with unit cells that include both GAA devices and forksheet devices, in accordance with an embodiment of the present disclosure. The figures represent cross-sectional views taken along the first direction through a given gate trench that crosses multiple devices within a multi-height cell. Each figure shows an example structure that results from the process flow up to that point in time, so the depicted structure evolves as the process flow continues, culminating in the structure shown in Figure 4G. Such a structure may be part of an overall integrated circuit (e.g., such as a processor or memory chip) that includes, for example, digital logic cells and/or memory cells and analog mixed signal circuitry. Thus, the illustrated integrated circuit structure may be part of a larger integrated circuit that includes other integrated circuitry not depicted. Example materials and process parameters are given, but the present disclosure is not intended to be limited to any specific such materials or parameters, as will be appreciated.

Figure 4A illustrates a cross-sectional view of multiple material layers formed over a substrate, according to an embodiment of the present disclosure. Alternating material layers may be deposited over a substrate 401 including sacrificial layers 402 alternating with semiconductor layers 404. The alternating layers are used to form GAA transistor structures. Any number of alternating semiconductor layers 404 and sacrificial layers 402 may be deposited over substrate 401.

According to some embodiments, sacrificial layers 402 have a different material composition than semiconductor layers 404. In some embodiments, sacrificial layers 402 are silicon germanium (SiGe) while semiconductor layers 404 include a semiconductor material suitable for use as a nanoribbon such as silicon (Si), SiGe, germanium, or III-V materials like indium phosphide (InP) or gallium arsenide (GaAs). In examples where SiGe is used in each of sacrificial layers 402 and in semiconductor layers 404, the germanium concentration is different between sacrificial layers 402 and semiconductor layers 404. For example, sacrificial layers 402 may include a higher germanium content compared to semiconductor layers 404. In some examples, semiconductor layers 404 may be doped with either n-type dopants (to produce a p-channel transistor) or p-type dopants (to produce an n-channel transistor).

While dimensions can vary from one example embodiment to the next, the thickness of each sacrificial layer 402 may be between about 5 nm and about 20 nm. In some embodiments, the thickness of each sacrificial layer 402 is substantially the same (e.g., within 1-2 nm). The thickness of each of semiconductor layers 404 may be about the same as the thickness of each sacrificial layer 402 (e.g., about 5-20 nm). Each of sacrificial layers 402 and semiconductor layers 404 may be deposited using any known material deposition technique, such as chemical vapor deposition (CVD), plasma-enhanced chemical vapor deposition (PECVD), physical vapor deposition (PVD), or atomic layer deposition (ALD).

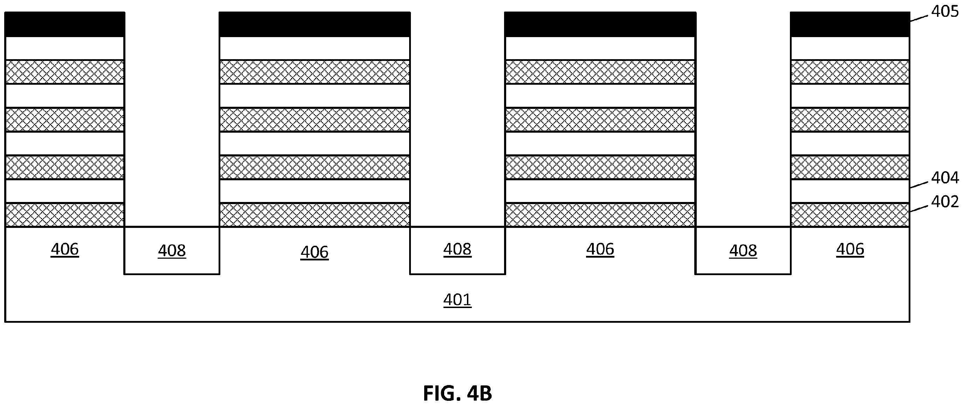

Figure 4B depicts the cross-section view of the structure shown in Figure 4A, following the formation of a cap layer 405 and the subsequent formation of fins beneath cap layer 405, according to an embodiment. Cap layer 405 may be any suitable hard mask material such as a carbon hard mask (CHM) or silicon nitride. Cap layer 405 is patterned into rows to form corresponding rows of fins from the alternating layer stack of sacrificial layers 402 and semiconductor layers 404. The rows of fins extend lengthwise in the second direction (e.g., into and out of the page of each cross-section view).

According to some embodiments, an anisotropic etching process through the layer stack continues into at least a portion of substrate 401, where the unetched portions of substrate 401 beneath the fins form subfin regions 406. The etched portions of substrate 401 may be filled with a dielectric fill 408 that acts as shallow trench isolation (STI) between adjacent fins. Dielectric fill 408 may be any suitable dielectric material such as silicon dioxide, and may be recessed to a desired depth as shown (in this example case, down to around the upper surface of subfin regions 406), so as to define the active portion of the fins that will be covered by a gate structure. In some embodiments, dielectric fill 408 is recessed below the top surface of subfin regions 406.

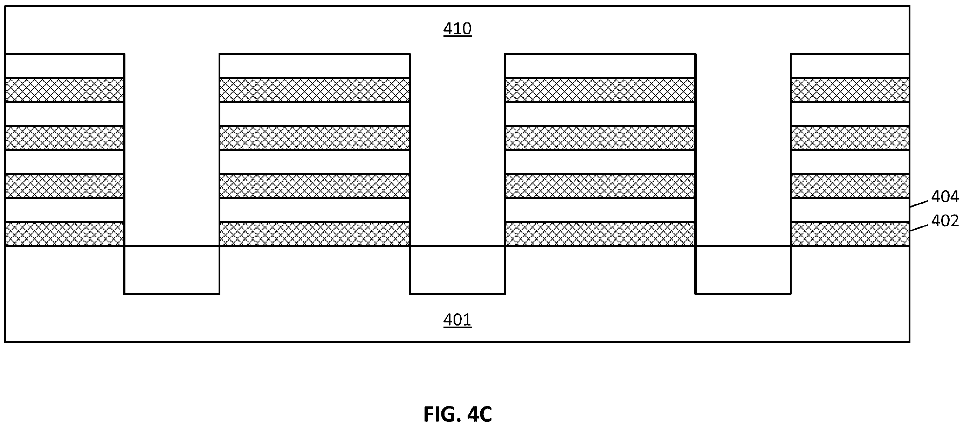

Figure 4C depicts the cross-section view of the structure shown in Figure 4B, following the formation of a sacrificial gate 410 extending across the fins in a second direction different from the first direction, according to some embodiments. Sacrificial gate 410 may extend across the fins in the first direction that is orthogonal to the second direction. According to some embodiments, the sacrificial gate material is formed in parallel strips across the integrated circuit and removed in all areas not protected by a gate masking layer. Sacrificial gate 410 may be any suitable material that can be selectively removed without damaging the semiconductor material of the fins. In some examples, sacrificial gate 410 includes polysilicon.

Sacrificial gate 410 (along with any gate spacers formed on the sidewalls of sacrificial gate 410) protect the underlying portions of the fins while the exposed portions of the fins between the gate spacers are etched away. According to some embodiments, both semiconductor layers 404 and sacrificial layers 402 are etched at substantially the same rate using an anisotropic RIE process to form source/drain trenches. In some embodiments, inner gate spacers can be formed after the source/drain trenches are etched and before any formation of source or drain regions. For instance, a selective etch can be used to laterally recess sacrificial layers 402, and that recess can then be filled with inner gate spacer material (e.g., silicon nitride or silicon oxynitride). Any excess gate spacer material can be removed with directional etching.

According to some embodiments, source or drain regions are formed after the formation of sacrificial gate 410. The source or drain regions are not shown in this cross-section as they would exist at the ends of the semiconductor layers 404 into and out of the page. The source or drain regions may be epitaxially grown from the exposed ends of semiconductor layers 404, such that the material grows together or otherwise merges towards the middle of the trenches between fins, according to some embodiments. Note that epitaxial growth on one semiconductor layer 404 can fully or partially merge with epitaxial growth on one or more other semiconductor layers 404 in the same vertical stack. The degree of any such merging can vary from one embodiment to the next. In the example of a PMOS device, a given source or drain region may be a semiconductor material (e.g., group IV or group III-V semiconductor materials) having a higher dopant concentration of p-type dopants compared to n-type dopants. In the example of an NMOS device, a given source or drain region may be a semiconductor material (e.g., group IV or group III-V semiconductor materials) having a higher dopant concentration of n-type dopants compared to p-type dopants. According to some embodiments, the source or drain regions grown from different semiconductor devices may be aligned along the source/drain trench in the first direction.

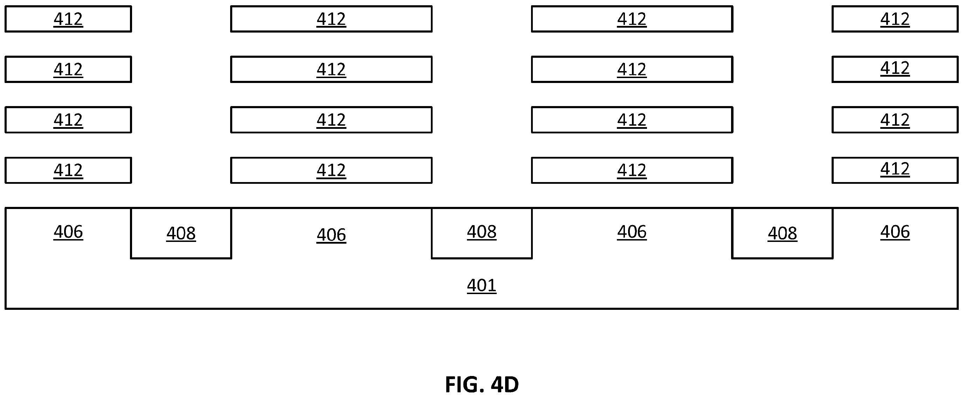

Figure 4D depicts the cross-section view of the structure shown in Figure 4C following the formation of nanoribbons 412 from semiconductor layers 404, according to some embodiments. Depending on the dimensions of the structures, nanoribbons 412 may also be considered nanowires or nanosheets. Sacrificial gate 410 may be removed using any wet or dry isotropic process thus exposing the alternating layer stack of the fins within the trenches left behind after the removal of sacrificial gate 410. Once sacrificial gate 410 is removed, sacrificial layers 402 may also be removed using a selective isotropic etching process that removes the material of sacrificial layers 402 but does not remove (or removes very little of) semiconductor layers 404 or any other exposed layers (e.g., inner gate spacers). At this point, the suspended (sometimes called released) semiconductor layers 404 form nanoribbons 412 that extend in the second direction (into and out of the page) between corresponding source or drain regions.

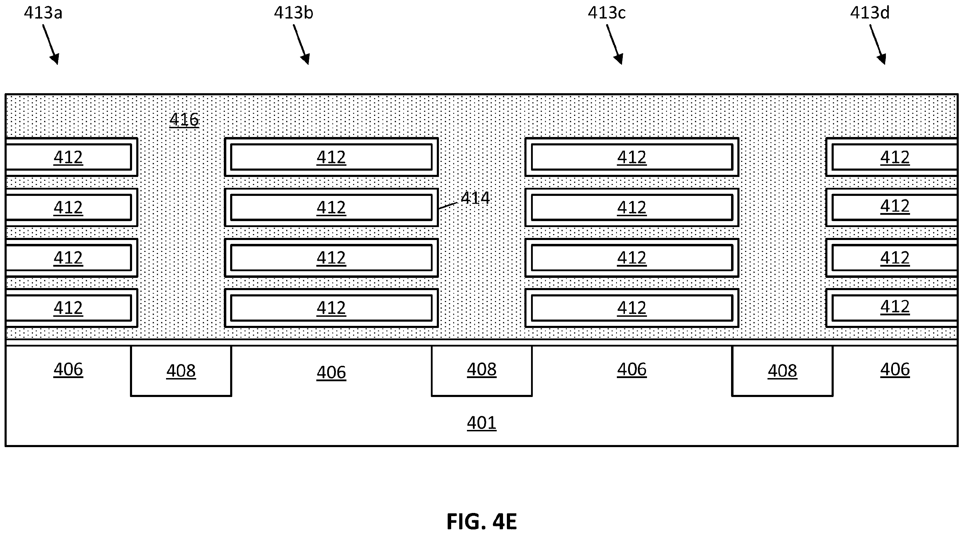

Figure 4E depicts the cross-section view of the structure shown in Figure 4D following the formation of a gate structure around nanoribbons 412 within the gate trench, according to some embodiments. As noted above, the gate structure includes a gate dielectric 414 and a gate electrode 416. Gate dielectric 414 may be conformally deposited around nanoribbons 412 using any suitable deposition process, such as atomic layer deposition (ALD). Gate dielectric 414 may include any suitable dielectric (such as silicon dioxide, and/or a high-k dielectric material). Examples of high-k dielectric materials include, for instance, hafnium oxide, hafnium silicon oxide, lanthanum oxide, lanthanum aluminum oxide, zirconium oxide, zirconium silicon oxide, tantalum oxide, titanium oxide, barium strontium titanium oxide, barium titanium oxide, strontium titanium oxide, yttrium oxide, aluminum oxide, lead scandium tantalum oxide, and lead zinc niobate, to provide some examples. According to some embodiments, gate dielectric 414 is hafnium oxide with a thickness between about 1 nm and about 5 nm. In some embodiments, gate dielectric 414 may include one or more silicates (e.g., titanium silicate, tungsten silicate, niobium silicate, and silicates of other transition metals). Gate dielectric 414 may be a multilayer structure, in some examples. For instance, gate dielectric 414 may include a first layer on nanoribbons 412, and a second layer on the first layer. The first layer can be, for instance, an oxide of the semiconductor layers (e.g., silicon dioxide) and the second layer can be a high-k dielectric material (e.g., hafnium oxide). In some embodiments, an annealing process may be carried out on gate dielectric 414 to improve its quality when a high-k dielectric material is used. In some embodiments, the high-k material can be nitridized to improve its aging resistance.

Gate electrode 416 may be deposited over gate dielectric 414 and can be any conductive structure. In some embodiments, gate electrode 416 includes doped polysilicon, a metal, or a metal alloy. Example suitable metals or metal alloys include aluminum, tungsten, cobalt, molybdenum, ruthenium, titanium, tantalum, copper, and carbides and nitrides thereof. Gate electrode 416 may include, for instance, one or more workfunction layers, resistance-reducing layers, and/or barrier layers. The workfunction layers can include, for example, p-type workfunction materials (e.g., titanium nitride) for PMOS gates, or n-type workfunction materials (e.g., titanium aluminum carbide) for NMOS gates.

According to some embodiments, any number of GAA devices may be formed along a given gate trench. In the illustrated example, GAA devices 413a - 413d are formed having the same gate structure. Each of GAA devices 413a - 413d may have substantially the same dimensions but may have source or drain regions with different dopant profiles (e.g., either n-type or p-type).

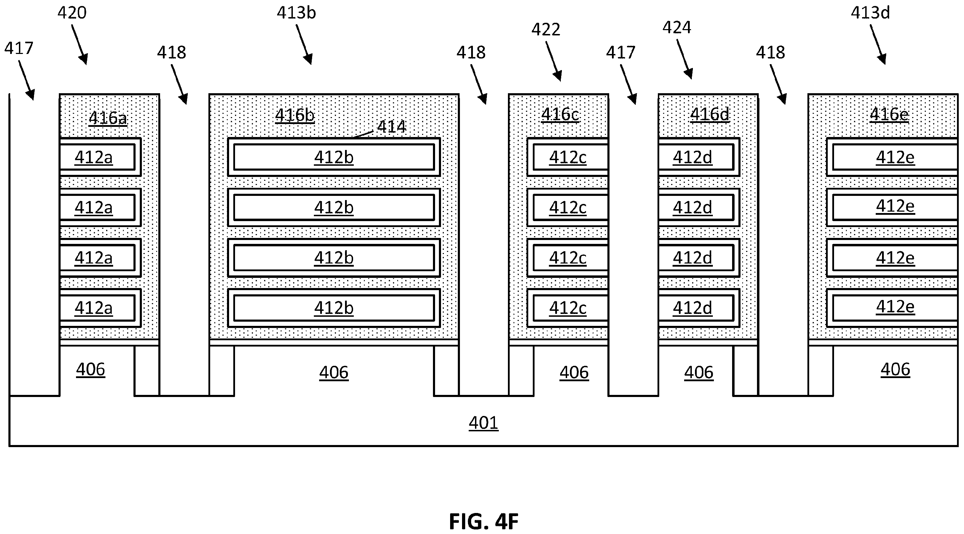

Figure 4F depicts the cross-section view of the structure shown in Figure 2E following the formation of deep recesses 417 and 418 throughout the structure, according to some embodiments. Both recesses 417 and 418 may be trenches that extend along the second direction across any number of adjacent cells. According to some embodiments, first recesses 417 extend in a third direction through a corresponding set of nanoribbons to form nanosheets, such as nanosheets 412a, 412c, and 412d. According to some embodiments, second recesses 418 extend in the third direction through the gate structure between devices to separate different devices from one another along the first direction. The third direction may be orthogonal to the first and second directions (e.g., along a Z-direction). Due to the locations of first and second recesses 417 and 418, GAA devices 413b and 413d may remain intact, while the other GAA devices have been split into corresponding forksheet devices 420, 422, and 424, according to some embodiments.

According to some embodiments, first and second recesses 417 and 418 also separate the gate structure along the first direction into different gate structures having corresponding gate electrodes 416a - 416e around gate dielectric 414. First and second recesses 417 and 418 may be formed at the same time using a reaction ion etching (RIE) process to cut through the various material (while protecting the other regions using a patterned masking layer). In other examples, first recesses 417 are formed using a first RIE process and a first masking layer, and second recesses 417 are formed at a later time (or vice versa) using a second RIE process and a second masking layer. Each of first recesses 417 and second recess 418 may extend in the third direction through at least an entire thickness of the gate structure and may also extend through an entire thickness of dielectric fill 408. Accordingly, first recesses 417 and/or second recesses 418 may extend into a portion of the underlying substrate 401.

Figure 4G depicts the cross-section view of the structure shown in Figure 2F following the formation of dielectric spines 426 within first recesses 417 and gate cuts 428 within second recesses 418, according to some embodiments. Dielectric spines 426 provide isolation between corresponding forksheet devices directly adjacent to opposite sides of dielectric spines 426. Accordingly, nanosheets 412a directly abut a first dielectric spine 426a, nanosheets 412c directly abut one side of a second dielectric spine 426b and nanosheets 412d directly abut an opposite side of second dielectric spine 426b. Gate cuts 428 may be used to separate adjacent devices from one another along the first direction.

Each of dielectric spines 426 and gate cuts 428 may be filled with one or more dielectric materials. In some examples, dielectric spines 426 and gate cuts 428 include the same dielectric material and are filled during the same dielectric deposition process or processes. In some embodiments, gate cuts 428 include a different dielectric material compared to dielectric spines 426. For example, gate cuts 428 may include silicon nitride and dielectric spines 426 may include silicon dioxide. In some examples, dielectric spines 426 may include any of silicon dioxide, silicon nitride, silicon oxynitride, aluminum oxide, or spin-on glass. In some examples, gate cuts 428 include a first dielectric layer deposited first and a second dielectric layer or dielectric fill formed on the first dielectric layer. The first dielectric layer may include a high-k dielectric material (e.g., materials with a dielectric constant higher than that of silicon oxide or higher than 3.9) while the second dielectric layer may include a low-k dielectric material (e.g. materials with a dielectric constant equal to or lower than that of silicon oxide, such as porous silicon oxide, or equal to or lower than 3.9).

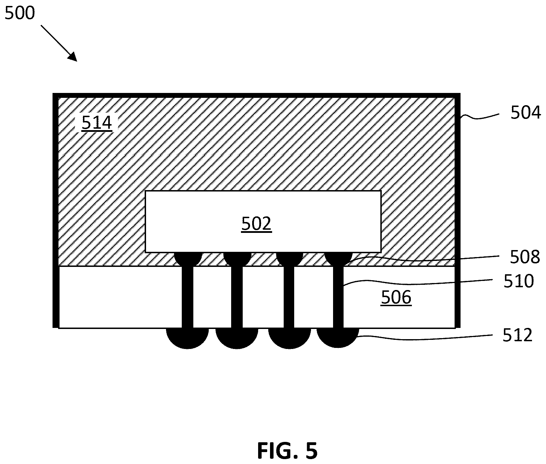

Figure 5 illustrates an example embodiment of a chip package 500, in accordance with an embodiment of the present disclosure. As can be seen, chip package 500 includes one or more dies 502. One or more dies 502 may include at least one integrated circuit having semiconductor devices, such as any of the semiconductor devices disclosed herein. One or more dies 502 may include any other circuitry used to interface with other devices formed on the dies, or other devices connected to chip package 500, in some example configurations.

As can be further seen, chip package 500 includes a housing 504 that is bonded to a package substrate 506. The housing 504 may be any standard or proprietary housing, and may provide, for example, electromagnetic shielding and environmental protection for the components of chip package 500. The one or more dies 502 may be conductively coupled to a package substrate 506 using connections 508, which may be implemented with any number of standard or proprietary connection mechanisms, such as solder bumps, ball grid array (BGA), pins, or wire bonds, to name a few examples. Package substrate 506 may be any standard or proprietary package substrate, but in some cases includes a dielectric material having conductive pathways (e.g., including conductive vias and lines) extending through the dielectric material between the faces of package substrate 506, or between different locations on each face. In some embodiments, package substrate 506 may have a thickness less than 1 millimeter (e.g., between 0.1 millimeters and 0.5 millimeters), although any number of package geometries can be used. Additional conductive contacts 512 may be disposed at an opposite face of package substrate 506 for conductively contacting, for instance, a printed circuit board (PCB). One or more vias 510 extend through a thickness of package substrate 506 to provide conductive pathways between one or more of connections 508 to one or more of contacts 512. Vias 510 are illustrated as single straight columns through package substrate 506 for ease of illustration, although other configurations can be used (e.g., damascene, dual damascene, through-silicon via, or an interconnect structure that meanders through the thickness of substrate 506 to contact one or more intermediate locations therein). In still other embodiments, vias 510 are fabricated by multiple smaller stacked vias, or are staggered at different locations across package substrate 506. In the illustrated embodiment, contacts 512 are solder balls (e.g., for bump-based connections or a ball grid array arrangement), but any suitable package bonding mechanism may be used (e.g., pins in a pin grid array arrangement or lands in a land grid array arrangement). In some embodiments, a solder resist is disposed between contacts 512, to inhibit shorting.

In some embodiments, a mold material 514 may be disposed around the one or more dies 502 included within housing 504 (e.g., between dies 502 and package substrate 506 as an underfill material, as well as between dies 502 and housing 504 as an overfill material). Although the dimensions and qualities of the mold material 514 can vary from one embodiment to the next, in some embodiments, a thickness of mold material 514 is less than 1 millimeter. Example materials that may be used for mold material 514 include epoxy mold materials, as suitable. In some cases, the mold material 514 is thermally conductive, in addition to being electrically insulating.

### Example System

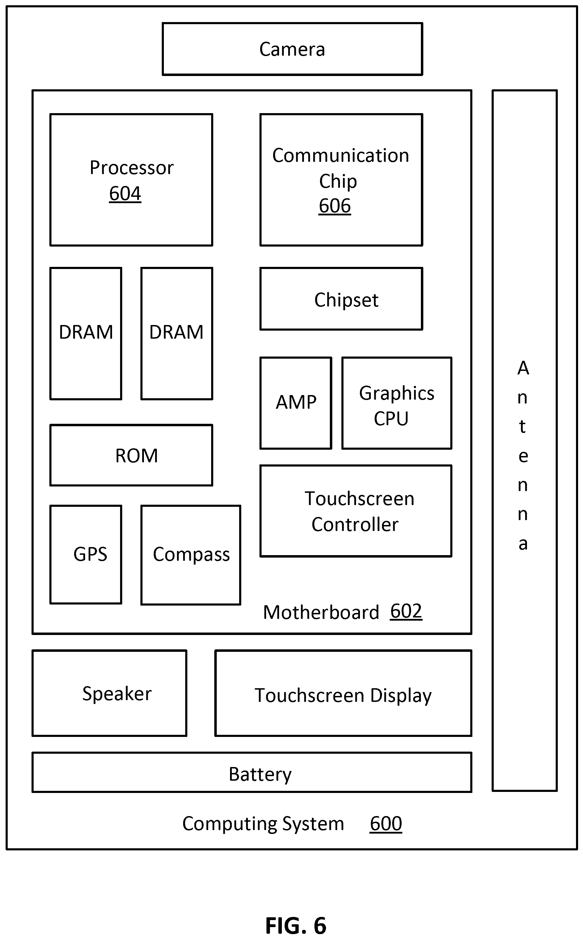

FIG. 6 is an example computing system implemented with one or more of the integrated circuit structures as disclosed herein, in accordance with some embodiments of the present disclosure. As can be seen, the computing system 600 houses a motherboard 602. The motherboard 602 may include a number of components, including, but not limited to, a processor 604 and at least one communication chip 606, each of which can be physically and electrically coupled to the motherboard 602, or otherwise integrated therein. As will be appreciated, the motherboard 602 may be, for example, any printed circuit board (PCB), whether a main board, a daughterboard mounted on a main board, or the only board of system 600, etc.

Depending on its applications, computing system 600 may include one or more other components that may or may not be physically and electrically coupled to the motherboard 602. These other components may include, but are not limited to, volatile memory (e.g., DRAM), non-volatile memory (e.g., ROM), a graphics processor, a digital signal processor, a crypto processor, a chipset, an antenna, a display, a touchscreen display, a touchscreen controller, a battery, an audio codec, a video codec, a power amplifier, a global positioning system (GPS) device, a compass, an accelerometer, a gyroscope, a speaker, a camera, and a mass storage device (such as hard disk drive, compact disk (CD), digital versatile disk (DVD), and so forth). Any of the components included in computing system 600 may include one or more integrated circuit structures or devices configured in accordance with an example embodiment (e.g., a module including an integrated circuit device on a substrate, the substrate having one or more unit cells that include both GAA devices and forksheet devices, as variously provided herein). In some embodiments, multiple functions can be integrated into one or more chips (e.g., for instance, note that the communication chip 606 can be part of or otherwise integrated into the processor 604).

The communication chip 606 enables wireless communications for the transfer of data to and from the computing system 600. The term "wireless" and its derivatives may be used to describe circuits, devices, systems, methods, techniques, communications channels, etc., that may communicate data through the use of modulated electromagnetic radiation through a non-solid medium. The term does not imply that the associated devices do not contain any wires, although in some embodiments they might not. The communication chip 606 may implement any of a number of wireless standards or protocols, including, but not limited to, Wi-Fi (IEEE 802.11 family), WiMAX (IEEE 802.16 family), IEEE 802.20, long term evolution (LTE), Ev-DO, HSPA+, HSDPA+, HSUPA+, EDGE, GSM, GPRS, CDMA, TDMA, DECT, Bluetooth, derivatives thereof, as well as any other wireless protocols that are designated as 3G, 4G, 5G, and beyond. The computing system 600 may include a plurality of communication chips 606. For instance, a first communication chip 606 may be dedicated to shorter range wireless communications such as Wi-Fi and Bluetooth and a second communication chip 606 may be dedicated to longer range wireless communications such as GPS, EDGE, GPRS, CDMA, WiMAX, LTE, Ev-DO, and others.

The processor 604 of the computing system 600 includes an integrated circuit die packaged within the processor 604. In some embodiments, the integrated circuit die of the processor includes onboard circuitry that is implemented with one or more semiconductor devices as variously described herein. The term "processor" may refer to any device or portion of a device that processes, for instance, electronic data from registers and/or memory to transform that electronic data into other electronic data that may be stored in registers and/or memory.

The communication chip 606 also may include an integrated circuit die packaged within the communication chip 606. In accordance with some such example embodiments, the integrated circuit die of the communication chip includes one or more semiconductor devices as variously described herein. As will be appreciated in light of this disclosure, note that multi-standard wireless capability may be integrated directly into the processor 604 (e.g., where functionality of any chips 606 is integrated into processor 604, rather than having separate communication chips). Further note that processor 604 may be a chip set having such wireless capability. In short, any number of processor 604 and/or communication chips 606 can be used. Likewise, any one chip or chip set can have multiple functions integrated therein.

In various implementations, the computing system 600 may be a laptop, a netbook, a notebook, a smartphone, a tablet, a personal digital assistant (PDA), an ultra-mobile PC, a mobile phone, a desktop computer, a server, a printer, a scanner, a monitor, a set-top box, an entertainment control unit, a digital camera, a portable music player, a digital video recorder, or any other electronic device that processes data or employs one or more integrated circuit structures or devices formed using the disclosed techniques, as variously described herein.

It will be appreciated that in some embodiments, the various components of the computing system 600 may be combined or integrated in a system-on-a-chip (SoC) architecture. In some embodiments, the components may be hardware components, firmware components, software components or any suitable combination of hardware, firmware or software.

### Further Example Embodiments

The following examples pertain to further embodiments, from which numerous permutations and configurations will be apparent.

Example 1 is an integrated circuit that includes a first semiconductor device having a first semiconductor region extending in a first direction from a first source or drain region, and a first gate structure extending in a second direction over the first semiconductor region. The integrated circuit also includes a second semiconductor device having a second semiconductor region extending in the first direction from a second source or drain region, and a second gate structure extending in the second direction over the second semiconductor region. The second source or drain region is adjacent to the first source or drain region along the second direction. The integrated circuit also includes a dielectric wall extending in the first direction between and contacting both the first semiconductor region and the second semiconductor region and extending in the first direction between both the first source or drain region and the second source or drain region. The first source or drain region and the second source or drain region both have n-type dopants, or both have p-type dopants.

Example 2 includes the integrated circuit of Example 1, wherein the dielectric wall directly separates the first gate structure from the second gate structure.

Example 3 includes the integrated circuit of Example 1 or 2, wherein the dielectric wall comprises silicon and nitrogen.

Example 4 includes the integrated circuit of any one of Examples 1-3, wherein the dielectric wall has a width in the first direction between about 5 nm and about 30 nm.

Example 5 includes the integrated circuit of any one of Examples 1-4, wherein the first semiconductor region comprises a plurality of first semiconductor nanosheets and the second semiconductor region comprises a plurality of second semiconductor nanosheets.

Example 6 includes the integrated circuit of Example 5, wherein the plurality of first semiconductor nanosheets and the plurality of second semiconductor nanosheets comprise germanium, silicon, or a combination thereof.

Example 7 includes the integrated circuit of any one of Examples 1-6, wherein the dielectric wall is a first dielectric wall and the integrated circuit further comprises a second dielectric wall extending in the second direction and adjacent to the first semiconductor device, such that the first gate structure extends in the first direction from the first dielectric wall to the second dielectric wall, and a third dielectric wall extending in the second direction and adjacent to the second semiconductor device, such that the second gate structure extends in the first direction from the first dielectric wall to the third dielectric wall.

Example 8 includes the integrated circuit of any one of Examples 1-6, wherein the dielectric wall is a first dielectric wall and the integrated circuit further comprises a third semiconductor device having a third semiconductor region extending from a third source or drain region, a fourth semiconductor device having a fourth semiconductor region extending in the second direction from a fourth source or drain region, and a second dielectric wall extending in the second direction between and contacting both the third semiconductor region and the fourth semiconductor region and extending in the second direction between both the third source or drain region and the fourth source or drain region. The third semiconductor device also includes a third gate structure where the third gate structure extends in the first direction over the third semiconductor region and the third semiconductor region extends in the second direction from the third source or drain region. The fourth semiconductor device also includes a fourth gate structure extending in the first direction over the fourth semiconductor region. The fourth source or drain region is adjacent to the third source or drain region along the first direction. The third source or drain region and the fourth source or drain region both have n-type dopants or both have p-type dopants.

Example 9 includes the integrated circuit of Example 8, further comprising a gate cut structure extending in the second direction and separating the second gate structure and the third gate structure.

Example 10 includes the integrated circuit of any one of Examples 1-6, wherein the dielectric wall is a first dielectric wall and the integrated circuit further comprises a third semiconductor device having a third semiconductor region extending from a third source or drain region in the second direction and a third gate structure extending over the third semiconductor region in the first direction, a fourth semiconductor device having a fourth semiconductor region extending in the second direction from a fourth source or drain region and a fourth gate structure extending in the first direction over the fourth semiconductor region, and a second dielectric wall extending in the second direction and contacting the fourth semiconductor region.

Example 11 includes the integrated circuit of Example 10, further comprising a gate cut structure extending in the second direction and separating the second gate structure and the third gate structure.

Example 12 includes the integrated circuit of Example 10 or 11, wherein the first, second and fourth semiconductor devices are forksheet transistor devices, and the third semiconductor device is a gate-all-around (GAA) transistor device.

Example 13 includes the integrated circuit of any one of Examples 1-6, wherein the first semiconductor region extends in the second direction from the first source or drain region to a third source or drain region and the second semiconductor region extends in the second direction from the second source or drain region to a fourth source or drain region, wherein the first, second, third, and fourth source or drain regions all have n-type dopants or all have p-type dopants.

Example 14 includes the integrated circuit of any one of Examples 1-13, wherein the n-type dopants comprise phosphorous and the p-type dopants comprise boron.

Example 15 includes the integrated circuit of any one of Examples 1-14, wherein the second direction is substantially perpendicular to the first direction.

Example 16 is a printed circuit board comprising the integrated circuit of any one of Examples 1-15.

Example 17 is an integrated circuit that includes a first semiconductor device having a first semiconductor region extending in a first direction from a first source or drain region to a second source or drain region, and a first gate structure extending in a second direction over the first semiconductor region, a first dielectric wall extending in the first direction and contacting the first semiconductor region, and extending in the first direction adjacent to both the first source or drain region and the second source or drain region, a second dielectric wall extending in the first direction and adjacent to the first semiconductor device, such that the first gate structure extends in the second direction from the first dielectric wall to the second dielectric wall, and a second semiconductor device having a second semiconductor region extending in the first direction from a third source or drain region to a fourth source or drain region, and a second gate structure extending in the second direction from the second dielectric wall and surrounding the second semiconductor region.

Example 18 includes the integrated circuit of Example 17, wherein the first dielectric wall and the second dielectric wall each comprise silicon and nitrogen.

Example 19 includes the integrated circuit of Example 17 or 18, wherein the first semiconductor region comprises a plurality of semiconductor nanosheets and the second semiconductor region comprises a plurality of semiconductor nanoribbons.

Example 20 includes the integrated circuit of Example 19, wherein the plurality of semiconductor nanosheets and the plurality of semiconductor nanoribbons comprise germanium, silicon, or a combination thereof.

Example 21 includes the integrated circuit of any one of Examples 17-20, wherein the first source or drain region and the second source or drain region both have n-type dopants and the third source or drain region and the fourth source or drain region both have p-type dopants, or the first source or drain region and the second source or drain region both have p-type dopants and the third source or drain region and the fourth source or drain region both have n-type dopants.

Example 22 includes the integrated circuit of Example 21, wherein the n-type dopants comprise phosphorous and the p-type dopants comprise boron.

Example 23 includes the integrated circuit of any one of Examples 17-22, further comprising a third dielectric wall extending in the second direction and adjacent to the second semiconductor device, such that the second gate structure extends in the first direction from the second dielectric wall to the third dielectric wall.

Example 24 includes the integrated circuit of any one of Examples 17-23, wherein the second direction is substantially perpendicular to the first direction.

Example 25 is a printed circuit board comprising the integrated circuit of any one of Examples 17-24.

Example 26 is an integrated circuit that includes a first semiconductor device having a first semiconductor region extending in a first direction from a first source or drain region, and a first gate structure extending in a second direction over the first semiconductor region. The integrated circuit also includes a second semiconductor device having a second semiconductor region extending in the first direction from a second source or drain region, and a second gate structure extending in the second direction over the second semiconductor region. The second source or drain region is adjacent to the first source or drain region along the second direction. The integrated circuit also includes a third semiconductor device having a third semiconductor region extending in the first direction from a third source or drain region and collinearly with the first semiconductor region and the second semiconductor region, and a third gate structure extending in the second direction over the third semiconductor region. The third gate structure is spaced from the first gate structure and second gate structure in the first direction. The integrated circuit also includes a dielectric wall extending in the first direction between and contacting both the first semiconductor region and the second semiconductor region, and extending in the first direction between both the first source or drain region and the second source or drain region. The dielectric wall does not intersect the third semiconductor region.

Example 27 includes the integrated circuit of Example 26, wherein the dielectric wall comprises silicon and nitrogen.

Example 28 includes the integrated circuit of Example 26 or 27, wherein the dielectric wall directly separates the first gate structure from the second gate structure.

Example 29 includes the integrated circuit of any one of Examples 26-28, wherein the first semiconductor region and second semiconductor region each comprise a plurality of semiconductor nanosheets and the third semiconductor region comprises a plurality of semiconductor nanoribbons.

Example 30 includes the integrated circuit of Example 29, wherein the plurality of semiconductor nanosheets and the plurality of semiconductor nanoribbons comprise germanium, silicon, or a combination thereof.

Example 31 includes the integrated circuit of any one of Examples 26-30, wherein the first source or drain region, the second source or drain region, and the third source or drain region all have n-type dopants or all have p-type dopants.

Example 32 includes the integrated circuit of Example 31, wherein the n-type dopants comprise phosphorous and the p-type dopants comprise boron.

Example 33 includes the integrated circuit of any one of Examples 26-32, wherein the dielectric wall is a first dielectric wall and the integrated circuit further comprises a second dielectric wall extending in the second direction and spaced from the first dielectric wall in the first direction. The second gate structure extends in the first direction from the first dielectric wall to the second dielectric wall, and the third gate structure extends from the second dielectric wall in the first direction.

Example 34 includes the integrated circuit of any one of Examples 26-33, wherein the second direction is substantially perpendicular to the first direction.

Example 35 is a printed circuit board comprising the integrated circuit of any one of Examples 26-34.

The foregoing description of the embodiments of the disclosure has been presented for the purposes of illustration and description. It is not intended to be exhaustive or to limit the disclosure to the precise forms disclosed. Many modifications and variations are possible in light of this disclosure. It is intended that the scope of the disclosure be limited not by this detailed description, but rather by the claims appended hereto.

## Claims

1. An integrated circuit comprising:
a first semiconductor device having a first semiconductor region extending from a first source or drain region, and a first gate structure extending over the first semiconductor region, the first gate structure extending in a first direction over the first semiconductor region and the first semiconductor region extending in a second direction from the first source or drain region;
a second semiconductor device having a second semiconductor region extending in the second direction from a second source or drain region, and a second gate structure extending in the first direction over the second semiconductor region, the second source or drain region being adjacent to the first source or drain region along the first direction; and
a dielectric wall extending in the second direction between and contacting both the first semiconductor region and the second semiconductor region, and extending in the second direction between both the first source or drain region and the second source or drain region, wherein the first source or drain region and the second source or drain region both have n-type dopants or both have p-type dopants.

2. The integrated circuit of claim 1, wherein the dielectric wall directly separates the first gate structure from the second gate structure.

3. The integrated circuit of claim 1 or 2, wherein the dielectric wall comprises silicon and nitrogen.

4. The integrated circuit of any one of claims 1 through 3, wherein the dielectric wall has a width in the first direction between about 5 nm and about 30 nm.

5. The integrated circuit of any one of claims 1 through 4, wherein the first semiconductor region comprises a plurality of first semiconductor nanosheets and the second semiconductor region comprises a plurality of second semiconductor nanosheets.

6. The integrated circuit of claim 5, wherein the plurality of first semiconductor nanosheets and the plurality of second semiconductor nanosheets comprise germanium, silicon, or a combination thereof.

7. The integrated circuit of any one of claims 1 through 6, wherein the dielectric wall is a first dielectric wall and the integrated circuit further comprises:
a second dielectric wall extending in the second direction and adjacent to the first semiconductor device, such that the first gate structure extends in the first direction from the first dielectric wall to the second dielectric wall; and
a third dielectric wall extending in the second direction and adjacent to the second semiconductor device, such that the second gate structure extends in the first direction from the first dielectric wall to the third dielectric wall.

8. The integrated circuit of any one of claims 1 through 6, wherein the dielectric wall is a first dielectric wall and the integrated circuit further comprises:
a third semiconductor device having a third semiconductor region extending from a third source or drain region, and a third gate structure extending over the third semiconductor region, the third gate structure extending in the first direction over the third semiconductor region and the third semiconductor region extending in the second direction from the third source or drain region;
a fourth semiconductor device having a fourth semiconductor region extending in the second direction from a fourth source or drain region, and a fourth gate structure extending in the first direction over the fourth semiconductor region, the fourth source or drain region being adjacent to the third source or drain region along the first direction; and
a second dielectric wall extending in the second direction between and contacting both the third semiconductor region and the fourth semiconductor region, and extending in the second direction between both the third source or drain region and the fourth source or drain region, wherein the third source or drain region and the fourth source or drain region both have n-type dopants or both have p-type dopants.

9. The integrated circuit of claim 8, further comprising a gate cut structure extending in the second direction and separating the second gate structure and the third gate structure.

10. The integrated circuit of any one of claims 1 through 6, wherein the dielectric wall is a first dielectric wall and the integrated circuit further comprises:
a third semiconductor device having a third semiconductor region extending from a third source or drain region, and a third gate structure extending over the third semiconductor region, the third gate structure extending in the first direction over the third semiconductor region and the third semiconductor region extending in the second direction from the third source or drain region;
a fourth semiconductor device having a fourth semiconductor region extending in the second direction from a fourth source or drain region, and a fourth gate structure extending in the first direction over the fourth semiconductor region; and
a second dielectric wall extending in the second direction and contacting the fourth semiconductor region.

11. The integrated circuit of claim 10, further comprising a gate cut structure extending in the second direction and separating the second gate structure and the third gate structure.

12. The integrated circuit of claim 10 or 11, wherein the first, second and fourth semiconductor devices are forksheet transistor devices, and the third semiconductor device is a gate-all-around (GAA) transistor device.

13. The integrated circuit of any one of claims 1 through 6, wherein the first semiconductor region extends in the second direction from the first source or drain region to a third source or drain region and the second semiconductor region extends in the second direction from the second source or drain region to a fourth source or drain region, wherein the first, second, third, and fourth source or drain regions all have n-type dopants or all have p-type dopants.

14. The integrated circuit of any one of claims 1 through 13, wherein the n-type dopants comprise phosphorous and the p-type dopants comprise boron.

15. A printed circuit board comprising the integrated circuit of any one of claims 1 through 14.
